(19) Europäisches Patentamt
European Patent Office
Office européen des brevets

(11) **EP 1 808 862 B1**

(12) **FASCICULE DE BREVET EUROPEEN**

(45) Date de publication et mention
de la délivrance du brevet:
**24.10.2012 Bulletin 2012/43**

(51) Int Cl.:
*G11C 11/15* $^{(2006.01)}$        *H01F 10/32* $^{(2006.01)}$
*G11C 11/56* $^{(2006.01)}$        *H01L 43/08* $^{(2006.01)}$
*H01L 27/22* $^{(2006.01)}$        *B82Y 25/00* $^{(2011.01)}$

(21) Numéro de dépôt: **07007334.1**

(22) Date de dépôt: **14.11.2002**

(54) **Dispositif magnétique à jonction tunnel magnétique, mémoire et procédés d'écriture et de lecture utilisant ce dispositif**

Magnetische Vorrichtung mit magnetischem Tunnelübergang, Speicher sowie Schreib- und Leseverfahren, die diese Vorrichtung nutzen

Magnetic device with magnetic tunnel junction, memory and read and write methods using this device

(84) Etats contractants désignés:
**AT BE BG CH CY CZ DE DK EE ES FI FR GB GR IE IT LI LU MC NL PT SE SK TR**

(30) Priorité: **16.11.2001 FR 0114840**

(43) Date de publication de la demande:
**18.07.2007 Bulletin 2007/29**

(62) Numéro(s) de document de la (des) demande(s) initiale(s) en application de l'article 76 CBE:
**02796844.5 / 1 466 329**

(73) Titulaire: **Commissariat à l'Énergie Atomique et aux Énergies Alternatives**
**75015 Paris (FR)**

(72) Inventeurs:
• **Dieny, Bernard**
**38250 Lans-en-Vercors (FR)**
• **Redon, Olivier**
**38170 Seyssinet Pariset (FR)**

(74) Mandataire: **Santarelli**
**14 Avenue de la Grande Armée**
**B.P. 237**
**75822 Paris Cedex 17 (FR)**

(56) Documents cités:
**EP-A1- 1 300 853        EP-B1- 1 466 329**
**WO-A-00/79540          WO-A-03/025946**
**WO-A-03/043017         US-A1- 2001 019 461**
**US-B1- 6 272 036       US-B1- 6 385 082**

**Description**

**DOMAINE TECHNIQUE**

La présente invention concerne un dispositif magnétique à jonction tunnel ainsi qu'une mémoire utilisant ce dispositif.

L'invention concerne aussi un procédé d'écriture thermomagnétique dans ce dispositif ainsi qu'un procédé de lecture du dispositif.

L'invention trouve une application en électronique et notamment dans la réalisation de points mémoires et de mémoires de type MRAM ("Magnetic Random Access Memory" ou mémoire magnétique à accès direct (ou aléatoire)).

**ETAT DE LA TECHNIQUE ANTÉRIEURE**

Les mémoires magnétiques MRAM ont connu un regain d'intérêt avec la mise au point de jonctions tunnel magnétiques (en abrégé MTJ pour "Magnetic Tunnel Junction") présentant une forte magnétorésistance à température ambiante.

Au sujet des mémoires magnétiques utilisant des jonctions tunnel magnétiques, on consultera par exemple les documents suivants :

[1] US 5 640 343 A (Gallagher et al.)
[2] S.S.P. Parkin et al., J.Appl.Phys., vol.85 n°8,1999, pp.5828-5833.

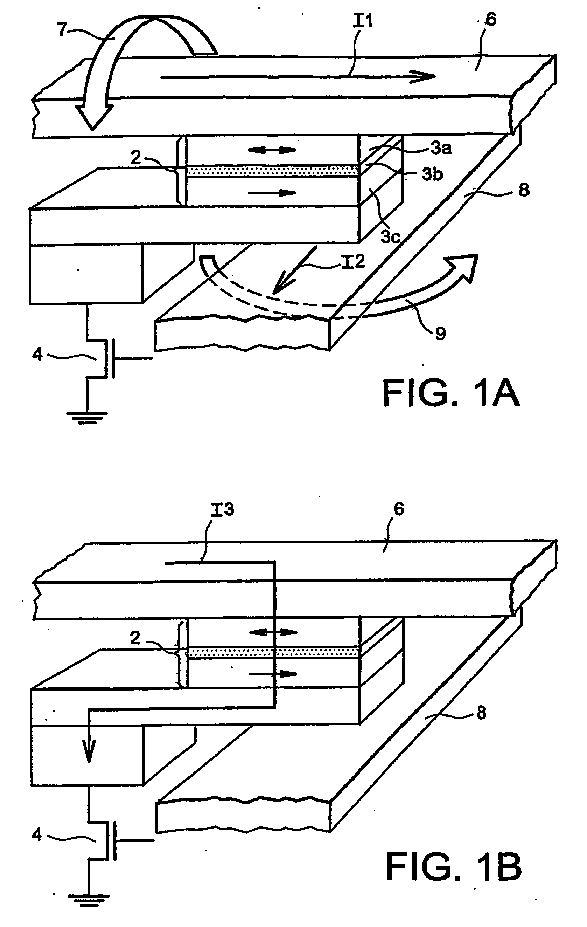

Les figures 1A et 1B annexées illustrent schématiquement la structure et la fonction d'une jonction tunnel magnétique connue.

La jonction porte la référence 2. Il s'agit d'un empilement comprenant une couche d'oxyde 3b en sandwich entre deux couches magnétiques. Ce système fonctionne comme une vanne de spin, à la différence que le courant circule perpendiculairement aux plans des couches.

L'une 3a des couches magnétiques est dite "libre" ou "de stockage" car on peut orienter son aimantation dans la direction désirée à l'aide d'un champ magnétique extérieur (flèche bidirectionnelle) ; l'autre couche magnétique 3c est dite "piégée" ou "de référence" car sa direction d'aimantation est fixée par couplage d'échange avec une couche antiferromagnétique (flèche unidirectionnelle).

Lorsque les aimantations des couches magnétiques sont antiparallèles, la résistance de la jonction est élevée ; lorsque les aimantations sont parallèles, cette résistance devient faible. La variation relative de résistance entre ces deux états peut atteindre 40% par un choix approprié des matériaux des couches de l'empilement et/ou de traitements thermiques de ces matériaux.

La jonction 2 est placée entre un transistor de commutation 4 et une ligne d'amenée de courant 6 formant une ligne conductrice supérieure. Un courant I1 passant dans celle-ci produit un premier champ magnétique 7. Un conducteur 8 formant une ligne conductrice inférieure, orthogonale à la ligne d'amenée de courant 6 permet, en y faisant circuler un courant I2, de produire un second champ magnétique 9.

Dans le mode "écriture" (figure 1A), le transistor 4 est placé en mode bloqué et aucun courant ne traverse donc ce transistor. On fait circuler des impulsions de courant dans la ligne d'amenée de courant 6 et dans le conducteur 8. La jonction 2 est donc soumise à deux champs magnétiques orthogonaux. L'un est appliqué selon l'axe de difficile aimantation de la couche libre 3a, afin de réduire son champ de retournement, tandis que l'autre et appliqué selon son axe facile afin de provoquer le retournement de l'aimantation et donc l'écriture du point mémoire.

Dans le principe, seul le point mémoire placé à l'intersection des deux lignes 6 et 8 est susceptible de se retourner, car chaque champ magnétique pris individuellement n'est pas suffisamment grand pour provoquer un basculement de l'aimantation.

Dans le mode "lecture" (figure 1B), le transistor est placé en régime saturé (c'est-à-dire que le courant traversant ce transistor est maximum) par l'envoi d'une impulsion de courant positive dans la grille du transistor. Le courant I3 envoyé dans la ligne 6 traverse uniquement le point mémoire dont le transistor est placé en mode saturé.

Ce courant permet de mesurer la résistance de la jonction de ce point mémoire. Par comparaison avec un point mémoire de référence, l'état du point mémoire ("O" ou "1") peut ainsi être déterminé : on sait alors si l'aimantation de la couche de stockage 3a est parallèle au antiparallèle à celle de la couche de référence 3c.

Un tel mécanisme d'écriture présente des inconvénients en particulier dans un réseau de jonctions tunnel :

1) Comme le renversement de l'aimantation de la couche libre d'une jonction se produit sous l'effet de champs extérieurs et comme les champs de retournement sont statistiquement distribués, il n'est pas impossible de retourner accidentellement certaines jonctions voisines simplement par l'effet du champ magnétique produit le long d'une ligne conductrice inférieure ou supérieure. Comme, pour des mémoires à haute densité, la taille des points mémoires est nettement submicronique, le nombre d'erreurs d'adressage augmente.

2) La diminution de la taille des points mémoires entraîne une augmentation de la valeur du champ de retournement individuel; un courant plus important est alors nécessaire pour écrire les points mémoires, ce qui tend à augmenter la consommation électrique.

3) Le mode d'écriture utilise deux lignes de courant à 90°, ce qui limite la densité d'intégration.

WO 00 79540 est considéré comme l'état de la technique le plus proche, et décrit avec sa figure 1A un dispositif comprenant une jonction tunnel magnétique qui comporte une premiere couche magnétique couplée à une couche antiferromagnétique, une deuxième couche magnétique et une troisième couche électriquement isolante qui sépare les deux premieres couches. L'effet de la couche antiferromagnétique est de rendre la premiere couche plus dure que la deuxième couche magnétique. Ce dispositif comporte en outre des moyens d'échauffement de la jonction, ces moyens étant en autre des moyens prévus pour faire circuler un courant d'électrons à travers la jonction tunnel magnétique et des moyens d'application d'un champ magnétique apte à orienter l'aimantation dans la cellule .

Cependant selon ce document, la température d'échauffement visée est supérieure à la température de blocage de l'aimantation de la couche antiferromagnétique et force ainsi la couche magnétique la plus dure à se re-orienter selon le champ magnétique impose.

Ce même document propose aussi un dispositif sans couche antiferromagnétique mais toujours composé d'une premiere couche magnétique plus dure que la deuxième couche magnétique. La température visée lors de l'échauffement est alors supérieure à la temperature de Curie des matériaux ferromagnétiques. Dans les deux cas exposés, la premiere couche magnétique magnétiquement plus dure voit ainsi son orientation magnétique changer, tout comme la deuxième couche.

## EXPOSE DE L'INVENTION

La présente invention a pour but de remédier aux inconvénients précédents.

Selon un aspect de la présente invention, on propose un dispositif magnétique à jonction tunnel magnétique qui est utilisable dans une MRAM et dans lequel le mécanisme d'écriture est insensible à la distribution des champs de retournement pour éliminer les erreurs d'adressage et obtenir une bonne reproductibilité de l'écriture des informations.

Selon un autre aspect de l'invention, on propose un dispositif magnétique à jonction tunnel magnétique dont la consommation en énergie est faible.

Selon encore un autre aspect, on propose un dispositif magnétique à jonction tunnel magnétique permettant un stockage multi-niveaux d'informations. Cela présente l'avantage, dans une mémoire conforme à l'invention, d'accroître la capacité de stockage pour un même nombre de points mémoires.

La présente invention a également pour but d'améliorer les mémoires magnétiques en diminuant la taille de leurs points mémoires, tout en gardant l'information stable à température ambiante, ainsi que le taux d'erreur d'écriture de ces mémoires.

Dans l'invention, on utilise une propriété connue d'un matériau magnétique, selon laquelle le champ de retournement de l'aimantation est très faible lorsqu'on élève la température de ce matériau au-delà de la température de blocage de l'aimantation de ce matériau.

De façon précise, la présente invention a pour objet le dispositif magnétique de la revendication 1.

La présente invention concerne également un procédé pour réaliser la commutation magnétique de l'aimantation de la couche de stockage tel que défini dans la revendication 13.

## BREVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :

- les figures 1A et 1B illustrent schématiquement le principe de fonctionnement d'un dispositif magnétique connu, à jonction tunnel, et ont déjà été décrites,
- la figure 2 est une vue schématique et partielle d'une mémoire comprenant une matrice de dispositifs magnétiques à jonction tunnel
- la figure 3 illustre schématiquement le principe de fonctionnement d'un dispositif magnétique à jonction tunnel,
- la figure 4 est une vue en coupe schématique d'un exemple de jonction tunnel dont des couches ont une aimantation perpendiculaire au plan de ces couches,
- la figure 5 est un graphique illustrant l'obtention de deux champs coercitifs différents en couplant à un matériau antiferromagnétique l'une des deux couches d'une jonction tunnel,

- la figure 6 est un graphique montrant les variations du champ de retournement en fonction de la température pour des multicouches,
- la figure 7 illustre schématiquement un exemple d'un ensemble de dispositifs magnétiques, utilisant des jonctions tunnel à aimantation perpendiculaire au plan de leurs couches,
- la figure 8 illustre schématiquement un exemple de dispositif magnétique conforme à l'invention, utilisant la combinaison d'un échauffement par effet Joule et d'une commutation magnétique par injection d'un courant d'électrons dont le spin est polarisé,
- la figure 9 est une vue en coupe schématique d'un exemple de jonction tunnel ayant une aimantation planaire.
- la figure 10 est une vue schématique d'un exemple de dispositif magnétique utilisant une jonction tunnel à aimantation planaire, et
- la figure 11 est une vue schématique d'un autre exemple d'un tel dispositif.

## EXPOSE DETAILLE DE MODES DE REALISATION PARTICULIERS

Dans un exemple de la présente invention, une mémoire magnétique comprend une matrice de dispositifs magnétiques conformes à l'invention. Chacun de ces dispositifs, également appelés "points mémoires", comprend une jonction tunnel magnétique de la forme F1/0/F2 où F1 et F2 désignent respectivement la couche magnétique de stockage, également appelée "électrode magnétique de stockage", et la couche magnétique de référence, également appelée "électrode magnétique de référence", et O désigne la couche qui est comprise entre F1 et F2 et forme une barrière tunnel.

Chacune des couches F1 et F2 est caractérisée par un champ de retournement de son aimantation, champ qui est fonction de la température du matériau constituant cette couche.

Dans la présente invention, les matériaux des couches F1 et F2 sont choisis de sorte que la décroissance en température du champ de retournement de la couche F1, noté HcF1, soit beaucoup plus rapide que celle du champ de retournement de la couche F2, noté HcF2.

Typiquement, on choisit les matériaux des couches F1 et F2 de sorte que leurs champs de retournement soient, à température ambiante (environ 20°C), de l'ordre de 100 Oe (environ 8000 A/m) pour F1 (on rappelle que 1 Oe vaut $1000/(4\pi)$ A/m) et de l'ordre de 600 Oe (environ 48000 A/m) pour F2 et, à 200°C, de l'ordre de 5 Oe (environ 400 A/m) pour F1 et 400 Oe (environ 32000 A/m) pour F2.

En d'autres termes, on choisit les matériaux des couches F1 et F2 de sorte que la température de blocage de l'aimantation de la couche F1, également appelée "température de blocage magnétique" de la couche F1 ou, plus simplement, "température de blocage" de la couche F1, soit significativement plus faible que la température de blocage de l'aimantation de la couche F2.

Lors de l'écriture, le principe de la sélection d'un point mémoire consiste alors à provoquer un très bref échauffement (jusqu'à une température Tmax, typiquement jusqu'à 200°C) de ce point mémoire, échauffement qui a pour effet d'abaisser le champ de retournement de l'aimantation de la couche magnétique F1 dans laquelle l'information est stockée.

Le principe de fonctionnement du dispositif étant basé sur des variations de température, il semble évident que les couches de stockage et de référence doivent de préférence avoir des températures de blocage supérieures à la température de fonctionnement du dispositif hors échauffement.

De plus, le but de ce dispositif étant de stocker de l'information de façon stable, il est donc, aussi pour cette raison, préférable que ces couches aient des températures de blocage nettement supérieures à la température de fonctionnement du dispositif.

Pendant le refroidissement du point mémoire, un champ magnétique d'amplitude He tel que HcFl(Tmax) < He < HcF2(Tmax),

He étant ainsi typiquement compris entre environ 20 Oe et 60 Oe (environ 1600A/m et 4800A/m), est appliqué dans la direction dans laquelle on souhaite orienter l'aimantation de la couché de stockage F1.

L'aimantation de cette couche de stockage F1 s'oriente alors dans la direction du champ appliqué He alors que celle de la couche de référence F2, également appelée "couche piégée", reste toujours orientée dans la même direction.

L'échauffement de la jonction peut être contrôlé par l'envoi d'une brève impulsion de courant (de l'ordre de $10^4$A/cm$^2$ à $10^5$A/cm$^2$ pendant quelques nanosecondes) au travers de la jonction.

Le champ magnétique He est créé par l'envoi d'impulsions de courant dans des lignes conductrices situées dans des plans se trouvant au dessus et/ou au dessous des jonctions tunnel magnétiques.

Une deuxième possibilité pour faire commuter l'aimantation de la couche de stockage lors de son refroidissement peut consister à injecter dans cette couche un courant d'électrons dont le spin est polarisé, suivant l'une des techniques qui sont mentionnées plus loin.

La présente invention consiste dans ce cas à combiner l'échauffement du matériau de la couche de stockage, pour réduire le champ de retournement de l'aimantation de cette couche, avec l'application d'un couple magnétique à cette aimantation, lors du refroidissement de la couche de stockage, en faisant circuler un courant d'électrons dont le spin est polarisé à travers la couche de stockage.

Il est également possible de combiner la commutation, par application d'un champ local engendré par l'envoi d'un courant dans une ligne conductrice supérieure ou inférieure, avec l'injection d'un courant d'électrons à spin polarisé dans la couche de stockage de la jonction.

Quatre avantages majeurs de la présente invention peuvent être mis en avant :

1) Sélection sans faille des points mémoires :

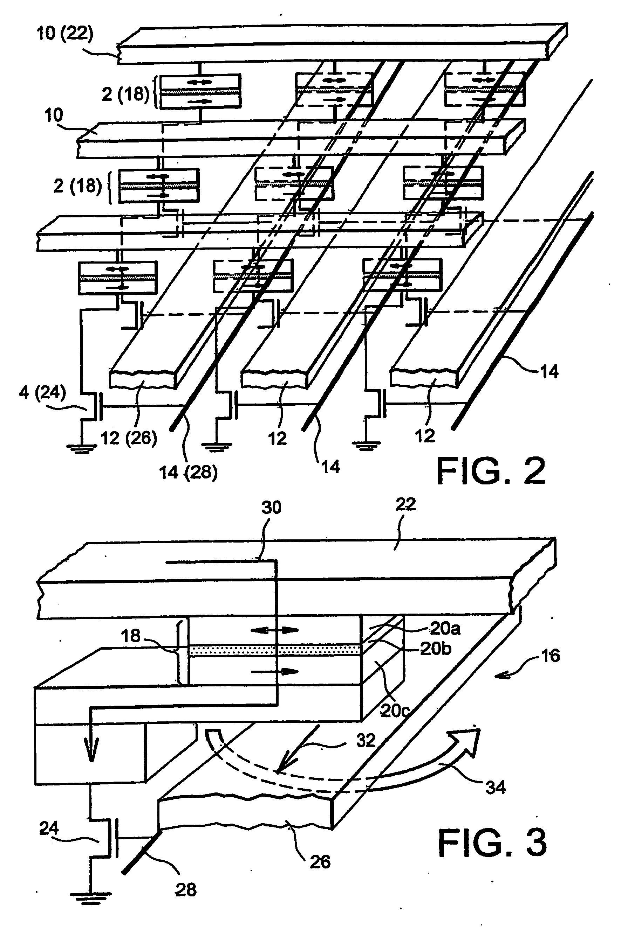

La présente invention permet une bien meilleure sélection des points mémoires que les techniques connues. En effet, supposons que les points mémoires soient organisés en un réseau carré comme on le voit sur la figure 2 qui représente l'architecture d'une mémoire MRAM connue.

Dans cette mémoire connue, on distingue trois niveaux de lignes :

- les lignes conductrices supérieures 10 qui servent à générer le champ magnétique Hx à appliquer aux jonctions tunnel magnétiques 2 lors de l'écriture et qui servent aussi de contacts électriques pour ces jonctions lors de la lecture,
- les lignes conductrices inférieures 12 qui servent uniquement à générer le champ magnétique Hy au moment de l'écriture, et
- les lignes de contrôle 14 qui agissent sur la grille des transistors 4 pour les mettre en position passante (saturée) ou fermée (bloquée).

Selon un procédé d'écriture connu, l'écriture se fait en envoyant des impulsions de courant le long des lignes conductrices supérieure et inférieure qui se croisent au point mémoire que l'on souhaite adresser. Or, s'il existe une distribution de champ de retournement, certains points mémoires situés le long des lignes risquent de se retourner de façon incontrôlée.

Dans la présente invention, ce problème ne se pose pas. Ceci est schématiquement illustré par la figure 3 où l'on voit un dispositif magnétique 16, formant un point mémoire, ou cellule, d'une mémoire MRAM.

Ce point mémoire comprend une jonction tunnel magnétique 18, comportant une couche de stockage 20a, une couche de référence 20c et une couche isolante ou semiconductrice 20b entre ces dernières. Cette jonction est placée entre une ligne conductrice supérieure 22 et un transistor de commutation 24 et associée à une ligne conductrice inférieure 26 qui est perpendiculaire à la ligne 22.

En rendant passant le transistor 24 du point mémoire 16, ce transistor étant commandé par une ligne de contrôle 28, et en envoyant une impulsion de courant 30 dans la ligne conductrice supérieure 22 correspondante, cette impulsion de courant traverse la jonction 18 et provoque son échauffement.

Or les jonctions de la mémoire de la figure 3 sont organisées en réseau carré comme dans la mémoire de la figure 2 (dont les références des éléments sont d'ailleurs suivies, entre parenthèses, des références des éléments correspondants de la figure 3). Donc seule une jonction de tout le réseau sera échauffée par l'impulsion de courant 30, toutes les autres restant à température ambiante.

L'abaissement de champ de retournement lié à l'élévation de température (typiquement de 100 Oe, à 20°C, à 5 Oe, à 200°C) est beaucoup plus important que la largeur de la distribution de champ de retournement à température ambiante (typiquement 100 Oe $\pm$ 20 Oe).

En conséquence, en envoyant une impulsion de courant 32 dans la ligne conductrice inférieure 26, ce qui génère un champ magnétique 34 de l'ordre de 10 Oe pendant le refroidissement de la jonction adressée, on est sûr de ne faire commuter que l'aimantation de la couche de stockage 20a de cette jonction.

Cependant, la ligne 26 n'est pas indispensable pour créer le champ magnétique. On peut très bien utiliser la ligne supérieure 22 (utilisée dans un premier temps pour provoquer l'échauffement) pour générer dans un deuxième temps le champ magnétique lors du refroidissement.

Dans le cas de la figure 3, si l'on supprime la ligne 26, il faut veiller à ce que les directions d'aimantation des couches soient perpendiculaires à la ligne de courant 22 génératrice du champ magnétique (par exemple en faisant pivoter le dispositif).

Le fonctionnement du point mémoire 16 de la figure 3 est donc le suivant : le transistor d'adressage 24 étant à l'état passant, l'écriture se fait en envoyant une impulsion de courant à travers la jonction 18 pour échauffer la jonction jusque vers 200°C. Pendant le refroidissement de la jonction, une impulsion de courant est envoyée dans la ligne conductrice inférieure 26 pour générer un champ magnétique dans la couche de stockage 20a, qui a pour effet de faire commuter l'aimantation de cette couche dans la direction désirée.

La lecture se fait avec le transistor à l'état bloqué en faisant circuler un courant à travers la jonction (le courant étant plus faible que lors de l'écriture pour que l'échauffement soit moindre), ce qui permet d'en mesurer la résistance et donc de savoir si l'aimantation de la couche de stockage 20a est parallèle ou antiparallèle à celle de la couche de référence 20c.

2) Consommation réduite :

Compte tenu du fait que les champs à générer pour l'écriture sont beaucoup plus faibles que dans l'art antérieur (typiquement 10 Oe dans la présente invention contre 50 Oe dans l'art antérieur), l'intensité des impulsions de champ à envoyer dans les lignes conductrices est grandement réduite.

De plus, une seule impulsion dans la ligne conductrice inférieure est nécessaire dans le cas de la figure 3, contre une impulsion dans la ligne conductrice inférieure et une impulsion dans la ligne conductrice supérieure dans l'art antérieur.

La puissance nécessaire pour provoquer l'échauffement du point mémoire étant beaucoup plus faible que pour générer les impulsions de champ de 50 Oe (typiquement lpJ pour chauffer de 200°C une jonction tunnel magnétique de 150 nm x 150 nm contre plusieurs dizaines de pJ pour générer une impulsion de champ de 50 Oe le long d'une ligne de 500 points mémoires), il s'ensuit que la consommation électrique peut être divisée par 10 avec le principe de fonctionnement de la présente invention.

3) Stabilité de l'information pour de petites dimensions:

La présente invention permet d'utiliser, pour la couche de stockage, des matériaux à forte énergie de piégeage à température ambiante. Dans l'art antérieur, cela n'est pas possible car plus le piégeage de la couche de stockage est important, plus il faut fournir d'énergie pour faire commuter l'aimantation de la couche de stockage.

Dans la présente invention, on abaisse l'énergie de piégeage lors de l'écriture en échauffant le matériau. On peut donc se permettre d'avoir une énergie de piégeage forte à température ambiante. Cela présente un avantage considérable pour de petites dimensions. En effet, dans l'art antérieur, l'information stockée dans la couche de stockage devient instable par rapport aux fluctuations thermiques à température ambiante.

En effet, si K et V désignent respectivement l'anisotropie magnétique par unité de volume (ou, plus généralement, l'énergie de piégeage par unité de volume) et le volume de la couche de stockage, l'information devient instable si $KV < 25kT$ (où k est la constante de Boltzmann et T la température).

Pour un matériau donné, cette limite est toujours atteinte à un moment ou à un autre lorsqu'on diminue la taille du point mémoire alors que, dans la présente invention, on peut très bien compenser la diminution du volume par une augmentation de l'énergie de piégeage à température ambiante et donc réduire la taille du point mémoire autant que le permet le procédé de fabrication (par exemple lithographie/gravure) utilisé.

4) Simplicité de la réalisation si l'on utilise comme principe de commutation un échauffement plus une injection d'un courant d'électrons à spin polarisé :

En effet, il n'y a pas besoin, dans ce cas, de rajouter un niveau de lignes pour la génération des champs magnétiques locaux. La réalisation de l'ensemble des points mémoires s'en trouve simplifiée, ce qui peut permettre d'atteindre des densités d'intégration supérieures.

On reviendra plus loin sur l'utilisation, dans la présente invention, d'un courant d'électrons à spin polarisé.

Comme on l'a vu plus haut, la structure de base, dans la présente invention, comporte deux couches magnétiques F1 et F2 séparées par une barrière tunnel O de sorte que l'on peut noter cette structure F1/O/F2. Les deux couches magnétiques sont telles que le champ de retournement de l'aimantation de l'une de ces deux couches magnétiques (la couche de stockage) décroît beaucoup plus vite, lorsque la température augmente, que celui de l'autre couche magnétique (la couche de référence) .

Dans un mode de réalisation de l'invention, les aimantations des deux couches F1 et F2 sont perpendiculaires au plan des couches ou, plus précisément, aux interfaces de ces couches.

Des couches F1 et F2 peuvent être constituées d'un matériau pur, d'un alliage ou d'un ensemble de couches alternées dont certaines sont magnétiques.

Des couches de Co, de structure hexagonale, ont leur aimantation perpendiculaire au plan de ces couches si l'axe c de la maille hexagonale est perpendiculaire au plan de l'échantillon contenant ces couches. Des couches en alliages tels que CoPt, FePd et FePt peuvent aussi avoir des aimantations perpendiculaires à leur plan. Enfin, des multicouches comprenant une alternance de couches de deux matériaux différents dont au moins l'un est magnétique, comme par exemple Co 0,6nm/Pt 1,4nm, peuvent aussi avoir des aimantations perpendiculaires au plan.

Le cobalt peut être aisément remplacé par un alliage riche en Co (supérieur à 70%) avec par exemple du Fe ou du Ni ou du Cr.

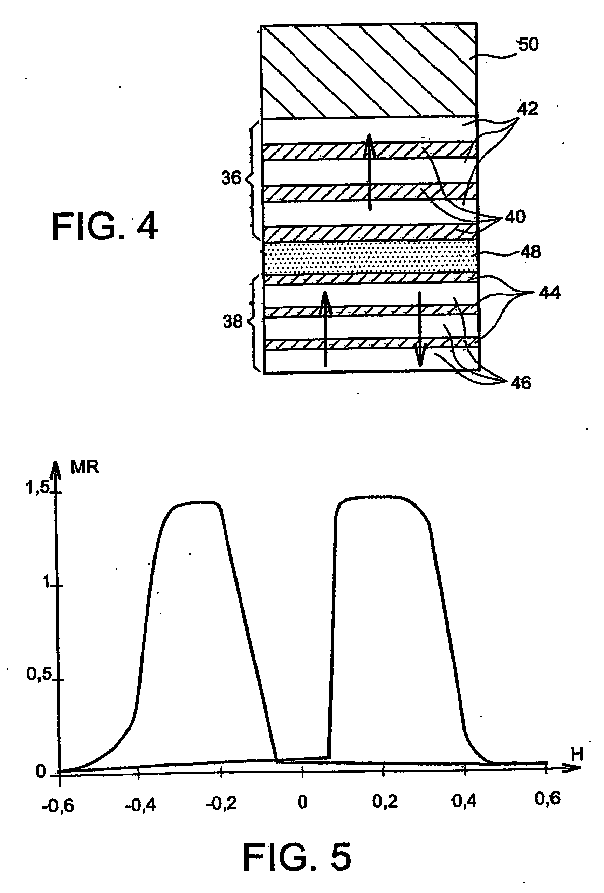

Un exemple de réalisation d'une jonction tunnel magnétique à base de multicouches Co/Pt, est montré sur la figure 4.

Plus précisément, comme on le voit sur la figure 4, cette jonction tunnel magnétique comprend une couche de référence 36 et une couche de stockage 38 qui ont une aimantation perpendiculaire au plan de ces couches; la couche de référence 36 comprend des couches 40 en cobalt qui alternent avec des couches 42 en platine; de même, la couche de stockage 38 comprend des couches 44 en cobalt qui alternent avec des couches 46 en platine; les couches 36 et 38 sont séparées par une couche de barrière tunnel 48 en alumine.

En jouant sur les épaisseurs relatives de Co et de Pt, on peut faire varier la coercitivité du matériau constitutif de chacune des couches 36 et 38 ainsi que la variation de cette coercitivité en fonction de la température. On peut aussi augmenter l'énergie de piégeage de l'aimantation de l'une des couches (la couche de référence 36) en la couplant à un matériau antiferromagnétique 50 à forte température de blocage, comme PtMn ou PtPdMn.

Dans ce cas, la couche ferromagnétique adjacente voit la valeur de sa température de blocage augmenter jusqu'à la valeur de celle de la couche antiferromagnétique.

D'autres exemples de multicouches à anisotropie perpendiculaire, sont par exemple Co/Pd, Co/Ni, Cu/Ni.

A titre d'exemple, la figure 5 montre qu'on peut obtenir une structure à aimantation perpendiculaire au plan, qui associe deux multicouches de coercivités différentes.

On a tracé les variations de la magnétorésistance MR (en%) en fonction du champ magnétique appliqué H (en kOe) pour la structure

$$NiO_{300}/Co_6/ (Pt_{18}/Co_6)_2/Cu_{30}/ (Co_6/Pt_{18})_2.$$

Dans le cas de la figure 5, l'augmentation de coercitivité de l'une des multicouches est obtenue en couplant l'aimantation de cette multicouche a une couche antiferromagnétique adjacente (par exemple NiO (cas de la figure 5), PtMn, PdPtMn ou FeMn):

Le même résultat pourrait être obtenu en associant une multicouche de Co/Pt à un alliage de FePt.

Par ailleurs, chacun des matériaux précités a sa propre variation de champ coercitif en fonction de la température.

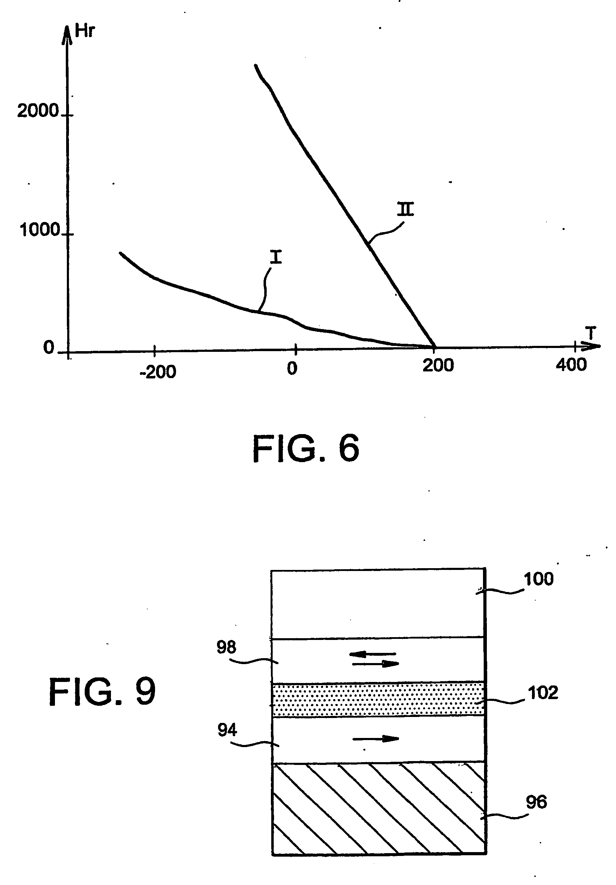

La figure 6 montre par exemple les variations du champ de retournement Hr (en Oe) d'une multicouche (Co 0,6nm/Pt 1,4nm) en fonction de la température T (en °C) pour une plaque "pleine tranche", de dimension latérale macroscopique (courbe I), et dans des réseaux (en anglais "arrays") de plots de dimensions submicroniques (courbe II).

Pour les épaisseurs de Co et de Pt utilisées, le champ de retournement Hr décroît rapidement avec la température pour quasiment s'annuler à une température Tc de l'ordre de 200°C.

Si l'on augmente l'épaisseur de Co à épaisseur de Pt fixe, le champ de retournement décroît moins vite, c'est à dire s'annule à une température supérieure à 200°C. De même, dans l'alliage FePt, le champ de retournement s'annule vers 500°C.

Donc en réalisant par exemple une jonction tunnel magnétique qui associe une multicouche, formée d'une alternance de couches de Co et de couches de Pt, avec une électrode en alliage FePt, on réalise une structure dans laquelle en envoyant une impulsion de courant à travers la jonction, on élève la température de cette dernière jusque vers 200°C.

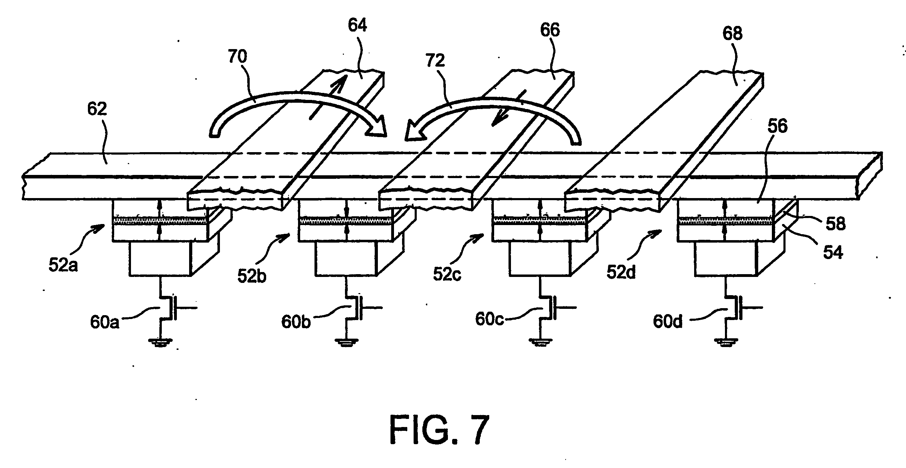

On coupe alors le courant qui circulait à travers la jonction et, pendant le refroidissement de cette jonction, on applique un faible champ magnétique à l'aide de lignes conductrices inférieures ou supérieures (voir la figure 7). L'aimantation de la couche de référence demeure inchangée alors que celle de la couche de stockage s'oriente dans la direction du champ appliqué pendant le refroidissement.

Plus précisément, la figure 7 illustre un exemple de réalisation d'un ensemble de plusieurs points mémoires à partir de jonctions tunnel à aimantation perpendiculaire au plan. Ces jonctions 52a, 52b, 52c et 52d comprennent chacune une couche de référence 54, une couche de stockage 56 et, entre celles-ci, une couche isolante ou semiconductrice 58. Ces jonctions 52a, 52b, 52c et 52d sont comprises entre des transistors de commutation 60a, 60b, 60c et 60d et une ligne conductrice 62.

On voit aussi des lignes conductrices supérieures, telle que les lignes 64, 66 et 68, qui sont situées de part et d'autre des jonctions.

Pour l'écriture d'un point mémoire, par exemple celui qui comprend la jonction 52b, cette jonction est chauffée au dessus de la température de blocage de la couche de stockage mais en dessous de la température de blocage de la couche de référence par l'envoi d'une impulsion à travers la jonction.

De plus, les transistors sont mis à l'état bloqué sauf le transistor 60b associé à la jonction 52b, qui est mis à l'état passant.

Les deux lignes conductrices supérieures 64 et 66 situées de part et d'autre de la jonction à adresser 52b sont alimentées par des courants sensiblement opposés pour créer deux champs magnétiques 70 et 72 sensiblement perpendiculaires au plan, qui s'ajoutent au niveau de la jonction à adresser. Ces champs servent à polariser l'aimantation de la couche de stockage pendant son refroidissement en dessous de sa température de blocage. L'aimantation de la couche de stockage peut prendre ici deux états (stockage binaire).

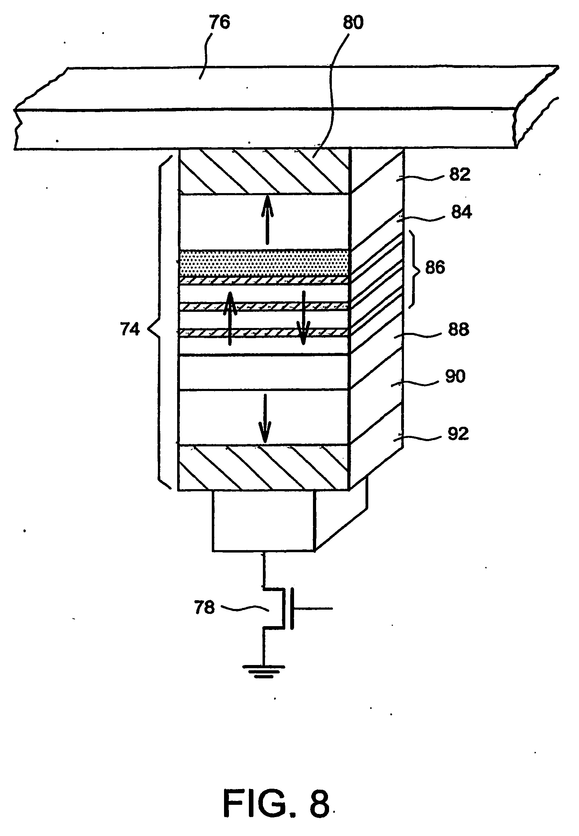

Une deuxième méthode pour réaliser la commutation lors du refroidissement consiste à injecter un courant d'électrons à spin polarisé à travers la couche de stockage. Une structure permettant de réaliser cette opération est représentée sur la figure 8 conforme à l'invention.

Sur cette figure 8, on voit un empilement 74 compris entre une ligne conductrice supérieure 76 et un transistor de commutation 78. L'empilement comprend, en allant de la ligne 76 au transistor 78, une couche 80 en PtMn, une couche de référence 82, une couche d'alumine 84, une couche de stockage 86, une couche de cuivre 88, une couche 90 dite "polarisante" et une couche 92 en PtMn.

La couche de stockage 86 est constituée ici d'un matériau à aimantation perpendiculaire dont le champ de retournement s'annule vers 200°C tel que par exemple une multicouche (Co/Pt). La couche de référence 82 est constituée d'un matériau dont le champ de retournement et l'aimantation restent importants à. 200°C, comme par exemple FePt. De même, l'aimantation de la deuxième couche magnétique de FePt formant la couche polarisante 90 reste importante à 200°C.

Le principe de la commutation magnétique est le suivant: on applique une impulsion de courant soit de haut en bas soit de bas en haut à travers la jonction tunnel.

Cette impulsion de courant a un profil particulier: elle monte à sa valeur maximum en un temps de l'ordre de lns à quelques nanosecondes puis redescend progressivement à zéro en quelques nanosecondes. Cette impulsion de courant a pour effet, dans un premier temps, d'échauffer la jonction puis, dans un deuxième temps, lors de la décroissance du courant c'est à dire lors du refroidissement de la jonction, d'orienter l'aimantation dans une direction particulière.

Si le courant circule de haut en bas (c'est à dire si les électrons circulent de bas en haut), des électrons à spin polarisé « vers le bas » sont injectés dans la multicouche de Co/Pt. De plus, les électrons qui vont traverser par effet tunnel la barrière d'alumine 84 sont préférentiellement des électrons dont le spin est parallèle à l'aimantation de la couche 82 de FePt et sont donc des électrons à spin « vers le haut ».

Cela va générer, dans la multicouche de Co/Pt, un excès d'électrons vers le bas. Cet excès d'électrons vers le bas, cumulé avec l'injection d'électrons vers le bas en provenance de la couche polarisante inférieure, va forcer l'aimantation de la multicouche de Co/Pt à s'orienter vers le bas lors de son refroidissement.

Au contraire, si le courant circule de bas en haut (c'est à dire si les électrons circulent de haut en bas), il va y avoir accumulation d'électrons « vers le haut » dans la couche de Co/Pt, ce qui aura pour effet de forcer l'aimantation de cette couche à s'orienter vers le haut lors de son refroidissement.

Précisons que ce principe de commutation magnétique pourrait fonctionner également sans la couche polarisante inférieure mais la forme de l'impulsion de courant serait alors plus difficile à ajuster pour trouver un bon équilibre entre une réduction du courant suffisante pour que la température de la jonction baisse suffisamment et une circulation de courant suffisante pour arriver à polariser l'aimantation de la couche de stockage lors de son refroidissement.

L'intérêt de la couche polarisante supplémentaire 90 est de permettre de cumuler le courant d'électrons à spin polarisé provenant de l'autre couche 82 de la jonction tunnel et le courant d'électrons à spin polarisé provenant de la couche polarisante 90.

Cette structure du point mémoire est particulièrement simple puisqu'elle ne nécessite, en plus du transistor d'adressage et de la jonction tunnel, qu'un niveau de ligne conductrice.

Dans un deuxième mode, les aimantations des deux couches F1 et F2 sont parallèles au plan des couches ou, plus précisément, aux interfaces de ces couches.

Comme précédemment, les matériaux magnétiques constitutifs de la jonction tunnel magnétique doivent être choisis de sorte que l'un présente une décroissance thermique de son champ coercitif plus rapide que l'autre.

Le matériau de la couche F2 de référence peut être en alliage à base de Co, Fe, Ni (par exemple $Co_{90}Fe_{10}$) et son aimantation peut être piégée par interaction d'échange avec un matériau antiferromagnétique à forte température de blocage (très supérieure à 200°C) comme PtMn.

Le matériau de la couche F1 peut être constitué d'un alliage dont la température de Curie est réduite en volume pour permettre de faciliter le basculement de son aimantation lorsque ce matériau est chauffé vers 200°C.

Un mode avantageux de réalisation de cette propriété consiste à coupler l'aimantation de la couche de stockage à une couche antiferromagnétique à faible température de blocage (par exemple $Fe_{50}Mn_{50}$ ou $Ir_{20}Mn_{80}$ dont la température de blocage est inférieure à 200°C tandis que l'aimantation de l'autre couche magnétique (la couche de référence) est couplée à un matériau antiferromagnétique à forte température de blocage, par exemple PtMn dont la température de blocage est supérieure à 280°C.

Ceci est schématiquement illustré par la figure 9 où l'on voit un exemple de jonction tunnel à aimantation planaire.

La couche de référence 94 en $CO_{90}Fe_{10}$ est piégée par interaction avec une couche antiferromagnétique 96 à haute température de blocage (très supérieure à 200°C), par exemple en PtMn ou en NiMn.

La couche de stockage 98 en $Ni_{80}Fe_{20}$ est couplée à une couche antiferromagnétique 100 à faible température de blocage (compris entre 100°C et 200°C), par exemple en $Fe_{50}Mn_{50}$ ou en $Ir_{20}Mn_{80}$ et cette couche 98 est séparée de la couche 94 par une couche de barrière tunnel 102 en $Al_2O_3$.

Notons qu'une façon de faire baisser la température de blocage de la couche antiferromagnétique couplée à la couche de stockage peut être de diminuer son épaisseur. On sait en effet que plus une couche antiferromagnétique est mince, plus sa température de blocage est basse.

L'écriture de l'information se fait comme précédemment en envoyant une impulsion de courant à travers la jonction, impulsion qui a pour effet d'échauffer le matériau de la couche de stockage (comprenant la couche antiferromagnétique adjacente) à une température permettant le retournement de l'aimantation de cette couche, alors que la couche de référence reste à une température suffisamment faible pour que son aimantation reste fixe.

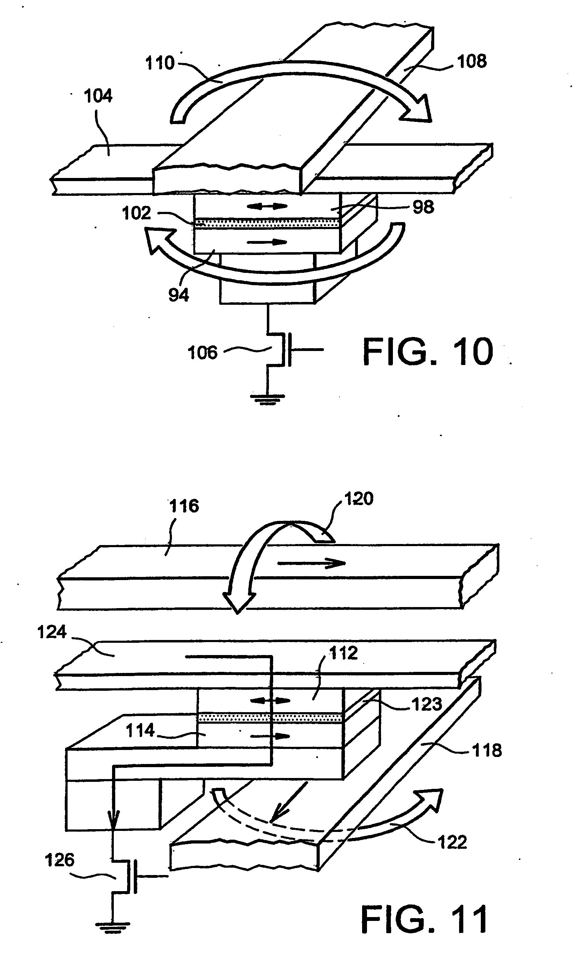

Ceci est schématiquement illustré par la figure 10 où l'on voit un exemple de réalisation d'un point mémoire à partir d'une jonction tunnel à aimantation planaire.

Pour l'écriture, la jonction est chauffée au dessus de la température de blocage de la couche de stockage 98 mais en dessous de la température de blocage de la couche de référence 94, par l'envoi d'une impulsion de courant à travers la jonction, cette impulsion se propageant de la ligne conductrice 104 au transistor 106, qui est alors rendu passant.

La ligne conductrice supérieure 108 sert à créer le champ magnétique 110 qui polarise l'aimantation de la couche de stockage 98 dans la direction désirée pendant son refroidissement. Cette aimantation de la couche de stockage ne peut prendre ici que deux états (stockage binaire).

Pour des raisons déjà données plus haut à propos d'autres exemples, la ligne 108 n'est pas obligatoire : sa fonction peut être avantageusement réalisée par la ligne 104. Dans ce cas, il faut aussi veiller à ce que les directions d'aimantation des couches soient orthogonales à la direction de la ligne 104.

Ce dispositif, dans lequel la couche de stockage est couplée à une couche antiferromagnétique dont la température de blocage est plus faible que la couche de référence, présente deux avantages majeurs:

1) La limite superparamagnétìque de stabilité de la couche de stockage est repoussée de sorte que l'on peut réaliser des points mémoires de taille plus petite en utilisant cette technique.

En effet, un problème qui apparaît toujours dans le stockage de l'information magnétique dans des points mémoires de petites dimensions (échelle submicronique) est celui de la stabilité de l'aimantation vis à vis des fluctuations thermiques (limite superparamagnétique).

Si K désigne l'anisotropie magnétique du matériau et V le volume de la couche magnétique de stockage, le temps caractéristique de renversement de l'aimantation par passage au dessus de la barrière d'énergie de hauteur KV est $\tau=\tau_0$exp (KV/(kT)) où $\tau_0$ est un temps caractéristique d'essai de l'ordre de $10^{-9}$ seconde, k la constante de Boltzman et T la température.

Pour que l'information que l'on écrit dans la couche de stockage reste stable pendant au moins 10 ans, il faut que l'aimantation elle-même reste stable pendant cette durée. Il faut donc que $\dfrac{KV}{kT} > \text{Log}(10\text{ans}/10^{-9}\text{s})$

c'est-à-dire : KV > 40kT.

Ceci impose une limite minimale au volume de la couche de stockage et donc à sa dimension latérale, c'est à dire une limite minimale à la dimension du point mémoire.

Par contre, si la couche magnétique de stockage est couplée à une couche antiferromagnétique dont l'anisotropie est relativement forte à température ambiante mais décroît rapidement lorsqu'on approche de la température de blocage de cette couche (vers 200°C), alors la limite superparamagnétique est repoussée.

En effet, la barrière d'énergie à franchir pour retourner l'aimantation de la couche de stockage à température ambiante vaut maintenant $A(K_f E_f + K_a E_a)$ où A désigne l'aire commune à la couche magnétique de stockage et à la couche antiferromagnétique, $E_f$ et $E_a$ désignent respectivement les épaisseurs de ces couches de stockage et antiferromagnétique et $K_f$ et $K_a$ désignent respectivement leurs anisotropies magnétiques.

Comme l'anisotropie $K_a$ du matériau antiferromagnétique est habituellement beaucoup plus forte que celle ($K_f$) de la couche ferromagnétique de stockage à température ambiante, il apparaît que la condition de stabilité $A(K_f E_f + K_a E_a)>40kT$ pourra être satisfaite pour des dimensions beaucoup plus petites que si la couche magnétique de stockage était seule.

Typiquement, le terme $K_a E_a$ peut être 100 fois plus grand à température ambiante que le terme $K_f E_f$. Ceci implique que l'aire de la jonction peut être 100 fois plus petite tout en restant au dessus de la limite superparamagnétique. Ceci permet donc d'atteindre des densités d'intégration beaucoup plus fortes.

Précisons qu'il est également possible d'utiliser ce couplage de la couche de stockage à une couche antiferromagnétique à faible température de Néel dans le cas précédemment décrit de couches magnétiques à aimantation perpendiculaire au plan. Là aussi, la limite superparamagnétique sera repoussée vers les plus petites dimensions à température ambiante.

2) Le deuxième avantage très important résultant de l'utilisation d'une couche de stockage couplée à une couche antiferromagnétique est de pouvoir réaliser un stockage de l'information multiniveaux.

En effet, avec les jonctions de l'art antérieur, un point mémoire a deux états possibles qui correspondent aux deux configurations magnétiques parallèle et antiparallèle, ces dernières correspondant respectivement à des alignements parallèle et antiparallèle de l'aimantation de la couche de stockage par rapport à celle de la couche de référence.

Ces systèmes de type bistables sont obtenus en donnant à la couche de stockage une anisotropie magnétique d'origine magnétocristalline ou de forme (point mémoire par exemple de forme elliptique), avec un axe facile d'aimantation parallèle à l'aimantation de la couche de référence.

L'aimantation de la couche de stockage peut être avantageusement orientée dans n'importe quelle direction intermédiaire entre la direction parallèle et la direction antiparallèle à l'aimantation de la couche de référence.

Pour ce faire, il suffit de chauffer la couche de stockage et la couche antiferromagnétique adjacente au dessus de la température de blocage de cette couche, en envoyant une impulsion de courant à travers la jonction, puis d'orienter l'aimantation de la couche de stockage dans la direction désirée au cours du refroidissement de la couche antiferromagnétique.

Pour donner l'orientation désirée à l'aimantation de la couche de stockage, il faut appliquer un champ magnétique local à cette dernière dans la direction désirée. Pour ce faire, deux possibilités existent:

1) On peut utiliser une architecture dans laquelle la commutation magnétique s'effectue en envoyant des impulsions de courant dans des lignes conductrices perpendiculaires qui sont respectivement situées au dessus et en dessous de ce point mémoire.

Ces lignes permettent de générer des champs magnétiques suivant deux directions perpendiculaires. En jouant sur l'intensité relative du courant circulant dans les deux lignes, on peut générer un champ magnétique dans n'importe quelle direction du plan.

Ceci est schématiquement illustré par la figure 11 qui montre un exemple de réalisation d'un point mémoire à partir d'une jonction tunnel à aimantation planaire.

Pour l'écriture, la jonction tunnel magnétique est chauffée au dessus de la température de blocage de la couche de stockage 112 mais en dessous de la température de blocage de la couche de référence 114, par l'envoi d'une impulsion de courant à travers la jonction.

Les lignes conductrices supérieure 116 et inférieure 118 servent à créer des champs magnétiques 120 et 122 suivant deux directions perpendiculaires dans le plan, qui permettent de polariser l'aimantation de la couche de stockage 112 dans n'importe quelle direction désirée dans le plan de la jonction, pendant son refroidissement.

Comme on l'a déjà expliqué précédement à propos de la figure 10, la ligne 116 n'est pas indispensable : elle peut être remplacée par la ligne 124.

L'aimantation de la couche de stockage peut donc prendre ici plus de deux états (stockage multiniveaux).. '

Sur la figure 11, la référence 123 désigne la couche de barrière tunnel. On voit aussi la ligne conductrice 124 et le transistor de commutation 126 entre lesquels la jonction est comprise et qui permettent de faire circuler un courant à travers cette jonction lorsque le transistor fonctionne en mode saturé.

2) On peut aussi utiliser la combinaison d'un champ magnétique créé comme précédemment, en faisant circuler un courant dans une ligne conductrice située au dessus ou en dessous de la jonction tunnel, avec le couple magnétique exercé par l'injection d'un courant d'électrons à spin polarisé à travers la jonction tunnel, dans la couche magnétique de stockage.

Dans ce cas, l'aimantation de la couche magnétique créant la polarisation du spin des électrons injectés devra être sensiblement perpendiculaire au champ magnétique généré par le courant circulant dans la ligne conductrice.

Il est également important dans ce cas de faire en sorte que la densité de courant nécessaire pour orienter l'aimantation de la couche de stockage dans la direction désirée soit sensiblement inférieure à celle qui est nécessaire à l'échauffement de la jonction de sorte que la jonction soit bien dans une phase de refroidissement en dessous de la température de blocage de la couche antiferromagnétique couplée à la couche de stockage durant ce processus d'écriture.

La lecture se fait en mesurant le niveau de résistance de la jonction.

En effet, la résistance varie suivant la loi

$$R = R_{par}\left[1 + \left(\frac{\Delta R}{R_{par}}\right)\left(\frac{1 - \cos(\theta_s - \theta_p)}{2}\right)\right]$$

où $\theta_s$ et $\theta_p$ représentent respectivement les angles repérant respectivement les aimantations de la couche de stockage et de la couche piégée, ou couche de référence, dans le plan de la jonction.

$\Delta R/R_{par}=(R_{ant}-R_{par})/R_{par}$ est l'amplitude totale de magnétorésistance.

La lecture du niveau de résistance intermédiaire entre la résistance parallèle $R_{par}$ et la résistance antiparallèle $R_{ant}$ permet donc de déterminer la direction de l'aimantation de la couche de stockage.

Dans les structures décrites précédemment, il est possible d'insérer de minces couches d'un autre matériau à l'interface entre la couche magnétique et la couche de barrière tunnel.

Ces minces couches peuvent être des couches magnétiques, destinées à renforcer la polarisation des électrons au voisinage de l'interface avec la couche de barrière tunnel, ou des couches non magnétiques permettant de réaliser des puits quantiques dépendant du spin au voisinage de la couche barrière tunnel ou d'augmenter le découplage magnétique des deux couches magnétiques de part et d'autre de la jonction tunnel.

## Revendications

1. Dispositif magnétique comprenant une jonction tunnel magnétique (74), qui comporte :

   - une première couche magnétique (82) formant une couche de référence et ayant une aimantation de direction fixe
   - une deuxième couche magnétique (86) formant une couche de stockage et ayant une aimantation de direction variable, et
   - une troisième couche (84) qui est électriquement isolante et qui sépare la première couche de la deuxième couche,

   **caractérisé en ce que** la température de blocage de l'aimantation de la couche de stockage est inférieure à la température de blocage de l'aimantation de la couche de référence et **en ce que** le dispositif comprend en outre ;

   - une quatrième couche magnétique (90) formant une couche de polarisation ayant une aimantation de direction fixe et opposée à celle de la première couche magnétique,
   - une cinquième couche conductrice (88) qui sépare la deuxième couche de la quatrième couche et
   - des moyens d'échauffement de la couche de stockage à une température supérieure à la température de blocage de l'aimantation de cette couche de stockage, les moyens d'échauffement de la couche de stockage étant des moyens (76-78) prévus pour faire circuler un courant d'électrons à travers la jonction tunnel magnétique, et
   - des moyens d'application, à cette couche de stockage, d'un couple magnétique apte à orienter l'aimantation de cette couche de stockage par rapport à l'aimantation de la couche de référence, sans modifier l'orientation de cette couche de référence.

2. Dispositif selon la revendication 1, **caractérisé en ce que** les moyens d'application du couple magnétique à la couche de stockage (86) comprennent des moyens d'injection, dans cette couche de stockage, d'un courant d'électrons dont le spin est polarisé.

3. Dispositif selon la revendication 2, **caractérisé en ce que** les moyens d'application du couple magnétique comprennent les couches de référence et polarisante (82, 90) traversées par une impulsion de courant pour produire des électrons à spin polarisé.

4. Dispositif selon l'une quelconque des revendications 1 à 3, **caractérisé en ce que** les aimantations des couches magnétiques de stockage (86), de référence (82) et polarisante (90) sont orientées sensiblement perpendiculairement au plan des couches.

5. Dispositif selon l'une quelconque des revendications 1 à 4, **caractérisé en ce que** la couche de stockage (86) est une multicouche.

6. Dispositif selon la revendication 5, **caractérisé en ce que** la multicouche de la couche de stockage (86) est en Co/Pt.

7. Dispositif selon l'une quelconque des revendications 1 à 6, **caractérisé en ce que** la couche de référence (82) est en FePt.

8. Dispositif selon l'une quelconque des revendications 1 à 7, **caractérisé en ce que** la couche polarisante (90) est en FePt.

**9.** Dispositif selon l'une quelconque des revendications 1 à 8, **caractérisé en ce que** l'aimantation de la couche de référence (82) est piégée par une couche antiferromagnétique (80).

**10.** Dispositif selon la revendication 9, **caractérisé en ce que** la couche antiferromagnétIque (80) est en PtMn.

**11.** Dispositif selon l'une quelconque des revendications 1 à 10, **caractérisé en ce que** l'aimantation de la couche polarisante (90) est piégée par une couche antiferromagnétique (92).

**12.** Dispositif selon la revendication 11, **caractérisé en ce que** la couche antiferromagnétique (92) est en PtMn.

**13.** Procédé pour réaliser la commutation magnétique de l'aimantation de la couche de stockage d'un dispositif magnétique selon l'une quelconque des revendications 1 à 12, **caractérisé par** la circulation d'une impulsion de courant à travers le dispositif perpendiculairement aux interfaces des couches constitutives de l'empilement, le courant circulant de la couche de référence vers la couche de stockage pour rendre l'aimantation de la couche de stockage antiparallèle à celle de la couche de référence et circulant de la couche de stockage vers la couche de référence pour rendre l'aimantation de la couche de stockage parallèle à celle de la couche de référence, le courant ayant un double effet: celui d'échauffer l'aimantation de la couche de stockage au dessus de sa température de blocage et d'exercer sur l'aimantation de la couche de stockage le couple permettant sa commutation,

**Claims**

**1.** Magnetic device comprising a magnetic tunnel junction (74) which includes:

- a first magnetic layer (82) forming a reference layer and having a magnetisation of fixed direction,
- a second magnetic layer (86) forming a storage layer and having a variable magnetisation direction, and
- a third layer (84) which is an electrically insulative layer and which separates the first layer from the second layer,

**characterised in that** the magnetisation blocking temperature of the storage layer is lower than the magnetisation blocking temperature of the reference layer and **in that** the device further comprises:

- a fourth magnetic layer (90) forming a polarisation layer having a magnetisation of fixed direction and opposing that of the first magnetic layer,
- a fifth conductive layer (88) which separates the second layer from the fourth layer and
- means for heating the storage layer to a temperature higher than the magnetisation blocking temperature of that storage layer, the storage layer heating means being means (76 - 78) provided for circulating a current of electrons across the magnetic tunnel junction, and
- means for applying to this storage layer a magnetic torque adapted to orient the magnetisation of this storage layer relative to the magnetisation of the reference layer without modifying the orientation of this reference layer.

**2.** Device according to claim 1 **characterised in that** the means for applying the magnetic torque to the storage layer (86) comprise means for injecting into this storage layer a current of electrons the spin whereof is polarised.

**3.** Device according to claim 2, **characterised in that** the means for applying the magnetic torque comprise the reference and polarising layers (82, 90) through which a current pulse is passed to produce polarised spin electrons.

**4.** Device according to any one of claims 1 to 3, **characterised in that** the magnetisations of the storage (86), reference (82) and polarising (90) magnetic layers are oriented substantially perpendicularly to the plane of the layers.

**5.** Device according to any one of claims 1 to 4, **characterised in that** the storage layer (86) is a multilayer.

**6.** Device according to claim 5, **characterised in that** the multilayer of the storage layer (86) is of Co/Pt.

**7.** Device according to any one of claims 1 to 6, **characterised in that** the reference layer (82) is of FePt.

**8.** Device according to any one of claims 1 to 7, **characterised in that** the polarising layer (90) is of FePt.

**9.** Device according to any one of claims 1 to 8, **characterised in that** the magnetisation of the reference layer (82) is trapped by an antiferromagnetic layer (80).

10. Device according to claim 9, **characterised in that** the antiferromagnetic layer (80) is of PtMn.

11. Device according to any one of claims 1 to 10, **characterised in that** the magnetisation of the polarising layer (90) is trapped by an antiferromagnetic layer (92).

12. Device according to claim 11, **characterised in that** the antiferromagnetic layer (92) is of PtMn.

13. Method for producing the magnetic switching of the magnetisation of the storage layer of a magnetic device according to any one of claims 1 to 12, **characterised by** the circulation of a current pulse through the device perpendicularly to the interfaces of the constituent layers of the stack, the current circulating from the reference layer to the storage layer to render the magnetisation of the storage layer antiparallel to that of the reference layer and circulating from the storage layer to the reference layer to render the magnetisation of the storage layer parallel to that of the reference layer, the current having a dual effect: that of heating the magnetisation of the storage layer above its locking temperature and of exerting on the magnetisation of the storage layer the torque allowing for its switching.

**Patentansprüche**

1. Magnetische Vorrichtung, umfassend eine magnetische Tunnelgrenzschicht (74), die umfasst:

- eine erste, eine Bezugsschicht bildende magnetische Schicht (82) mit einer Magnetisierung von festgelegter Richtung,
- eine zweite, eine Speicherschicht bildende magnetische Schicht (86) mit einer Magnetisierung von veränderlicher Richtung und
- eine dritte Schicht (84), die elektrisch isolierend ist und die erste Schicht von der zweiten Schicht trennt,

**dadurch gekennzeichnet, dass** die Temperatur der Blockierung der Magnetisierung der Speicherschicht niedriger als die Temperatur der Blockierung der Magnetisierung der Bezugsschicht ist und dass die Vorrichtung ferner umfasst:

- eine vierte, eine polarisierende Schicht bildende magnetische Schicht (90) mit einer Magnetisierung von festgelegter Richtung, die derjenigen der ersten magnetischen Schicht entgegengesetzt ist,
- eine fünfte, leitende Schicht (88), welche die zweite Schicht von der vierten Schicht trennt, und
- Mittel zum Erwärmen der Speicherschicht auf eine Temperatur, die höher als die Temperatur der Blockierung der Magnetisierung dieser Speicherschicht ist, wobei die Mittel zum Erwärmen der Speicherschicht Mittel (76 - 78) sind, die dazu vorgesehen sind, einen Elektronenstrom durch die magnetische Tunnelgrenzschicht fließen zu lassen, und
- Mittel zum Anlegen eines Magnetmoments an diese Speicherschicht, das in der Lage ist, die Magnetisierung dieser Speicherschicht bezüglich der Magnetisierung der Bezugsschicht auszurichten, ohne die Ausrichtung dieser Bezugsschicht zu ändern.

2. Vorrichtung nach Anspruch 1, **dadurch gekennzeichnet, dass** die Mittel zum Anlegen des Magnetmoments an die Speicherschicht (86) Mittel zum Einspritzen eines Stroms von Elektronen, deren Spin polarisiert ist, in diese Speicherschicht umfassen.

3. Vorrichtung nach Anspruch 2, **dadurch gekennzeichnet, dass** die Mittel zum Anlegen des Magnetmoments eine Bezugs- und eine polarisierende Schicht (82, 90) umfassen, die von einem Stromimpuls durchflossen werden, um Elektronen mit polarisiertem Spin zu erzeugen.

4. Vorrichtung nach einem der Ansprüche 1 bis 3, **dadurch gekennzeichnet, dass** die Magnetisierungen der Speicherschicht (86), der Bezugsschicht (82) und der polarisierenden Schicht (90) im Wesentlichen senkrecht zur Ebene der Schichten ausgerichtet sind.

5. Vorrichtung nach einem der Ansprüche 1 bis 4, **dadurch gekennzeichnet, dass** die Speicherschicht (86) eine Multischicht ist.

6. Vorrichtung nach Anspruch 5,
**dadurch gekennzeichnet, dass** die Multischicht der Speicherschicht (86) aus Co/Pt besteht.

7. Vorrichtung nach einem der Ansprüche 1 bis 6,
**dadurch gekennzeichnet, dass** die Bezugsschicht (82) aus FePt besteht.

8. Vorrichtung nach einem der Ansprüche 1 bis 7,
**dadurch gekennzeichnet, dass** die polarisierende Schicht (90) aus FePt besteht.

9. Vorrichtung nach einem der Ansprüche 1 bis 8,
**dadurch gekennzeichnet, dass** die Magnetisierung der Bezugsschicht (82) von einer antiferromagnetischen Schicht (80) aufgenommen wird.

10. Vorrichtung nach Anspruch 9,
**dadurch gekennzeichnet, dass** die antiferromagnetische Schicht (80) aus PtMn besteht.

11. Vorrichtung nach einem der Ansprüche 1 bis 10,
**dadurch gekennzeichnet, dass** die Magnetisierung der polarisierenden Schicht (90) von einer antiferromagnetischen Schicht (92) aufgenommen wird.

12. Vorrichtung nach Anspruch 11,
**dadurch gekennzeichnet, dass** die antiferromagnetische Schicht (92) aus PtMn besteht.

13. Verfahren zum Durchführen der magnetischen Umschaltung der Magnetisierung der Speicherschicht einer magnetischen Vorrichtung nach einem der Ansprüche 1 bis 12,
**gekennzeichnet durch**
das Fließen eines Stromimpulses **durch** die Vorrichtung senkrecht zu den Schnittstellen der den Stapel bildenden Schichten, wobei der Strom, der von der Bezugsschicht zur Speicherschicht fließt, um die Magnetisierung der Speicherschicht antiparallel zu derjenigen der Bezugsschicht zu schalten, und der von der Speicherschicht zur Bezugsschicht fließt, um die Magnetisierung der Speicherschicht parallel zu derjenigen der Bezugsschicht zu schalten, wobei der Strom eine zweifache Wirkung hat, nämlich dass die Speicherschicht über ihre Blockierungstemperatur erwärmt wird und dass auf die Magnetisierung der Speicherschicht das deren Umschaltung gestattende Moment ausgeübt wird.

**FIG. 1A**

**FIG. 1B**

10 (22)

2 (18)

10

2 (18)

4 (24)

12 (26)

14 (28)

12

14

12

14

**FIG. 2**

30

22

18

20a
20b

20c

24

32

16

34

28

26

**FIG. 3**

## FIG. 4

## FIG. 5

FIG. 6

FIG. 9

FIG. 7

FIG. 8

110    108

104

102    98

94

106    FIG. 10

116    120

124    112

123

114

118

122

126    FIG. 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5640343 A, Gallagher

- WO 0079540 A

**Littérature non-brevet citée dans la description**

- **S.S.P. PARKIN et al.** *J.Appl.Phys.,* 1999, vol. 85 (8), 5828-5833